(19) Europäisches Patentamt
European Patent Office
Office européen des brevets

(11) **EP 1 805 100 B1**

(12) **FASCICULE DE BREVET EUROPEEN**

(45) Date de publication et mention
de la délivrance du brevet:
**05.10.2011 Bulletin 2011/40**

(21) Numéro de dépôt: **05857762.8**

(22) Date de dépôt: **11.10.2005**

(51) Int Cl.:
***B81B 3/00*** *(2006.01)*

(86) Numéro de dépôt international:
**PCT/FR2005/002512**

(87) Numéro de publication internationale:
**WO 2006/045914 (04.05.2006 Gazette 2006/18)**

(54) **MICROSYSTEME COMPORTANT UN PONT DEFORMABLE**

MIKROSYSTEM MIT VERFORMBARER BRÜCKE

MICROSYSTEM COMPRISING A DEFORMABLE BRIDGE

(84) Etats contractants désignés:
**AT BE BG CH CY CZ DE DK EE ES FI FR GB GR
HU IE IS IT LI LT LU LV MC NL PL PT RO SE SI
SK TR**

(30) Priorité: **26.10.2004 FR 0411408**

(43) Date de publication de la demande:
**11.07.2007 Bulletin 2007/28**

(73) Titulaire: **Commissariat à l'Énergie Atomique
et aux Énergies Alternatives
75015 Paris (FR)**

(72) Inventeur: **CHARVET, Pierre-Louis
F-38950 Saint-Martin-Le-Vinoux (FR)**

(74) Mandataire: **Hecké, Gérard et al
Cabinet Hecké
10, rue d'Arménie
Europole
BP 1537
38025 Grenoble Cedex 1 (FR)**

(56) Documents cités:
**EP-A- 1 321 957        US-A- 5 867 202
US-A- 6 115 231        US-A1- 2003 132 824
US-A1- 2004 008 097**

## Description

### Domaine technique de l'invention

L'invention concerne un microsystème comportant un pont déformable, ayant deux extrémités et un axe longitudinal passant par ses deux extrémités, le pont étant rattaché uniquement par ses deux extrémités à un substrat, le microsystème comportant des moyens d'actionnement destinés à déformer le pont déformable perpendiculairement au substrat, de manière à ce qu'une zone centrale de la face inférieure du pont vienne en contact avec au moins un élément de contact formé sur ledit substrat, les moyens d'actionnement comportant au moins une électrode d'actionnement solidaire du pont et disposée, entre le centre du pont et une des extrémités, vis-à-vis d'une contre-électrode solidaire du substrat.

### État de la technique

Les microsystèmes comportant un pont déformable micro-mécanique sont utilisés, par exemple, pour réaliser des commutateurs radiofréquence ou pour réaliser des miroirs mobiles, par exemple en optique adaptative, en imagerie ou dans des dispositifs de télécommunication optique.

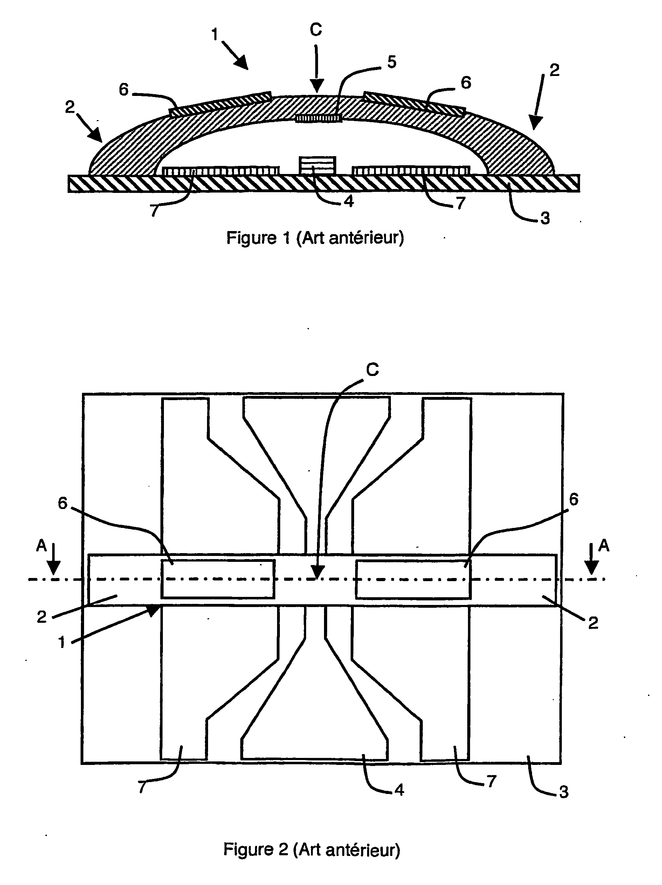

Comme représenté à la figure 1, un commutateur, par exemple, comporte typiquement un pont 1 déformable rattaché par ses extrémités 2 au substrat 3. Le commutateur comporte, de plus, un actionneur pour déformer le pont 1 déformable de manière à ce qu'une face inférieure du pont vienne en contact avec au moins un élément 4 de contact formé sur un substrat 3. La face inférieure du pont 1 comporte généralement un élément conducteur 5 qui permet d'établir un contact électrique avec l'élément de contact 4. Par exemple, deux éléments 4 de contact peuvent être constitués par deux tronçons d'une ligne radiofréquence qui sont reliés par l'élément conducteur 5.

L'actionneur représenté à la figure 1 comporte deux électrodes 6 d'actionnement solidaires du pont 1 et disposées entre le centre C du pont 1 et respectivement une des extrémités 2. Chacune des électrodes 6 d'actionnement est disposée vis-à-vis d'une contre-électrode 7 solidaire du substrat 3. Lorsqu'une tension électrique d'actionnement est appliquée entre les électrodes 6 d'actionnement et les contre-électrodes 7, une force électrostatique attractive entre chacune des électrodes 6 et l'électrode 7 correspondante provoque la déformation du pont 1 et permet, ainsi, d'établir le contact entre la face inférieure du pont 1 et l'élément 4 de contact.

Sur la figure 1, les électrodes 6 d'actionnement sont disposées à une face supérieure du pont 1. Ainsi, les électrodes 6 d'actionnement n'entrent pas en contact électrique avec les contre-électrodes 7, lorsque le pont se déforme. Les électrodes 6 d'actionnement peuvent également être disposées à la face inférieure du pont 1. Dans ce dernier cas, afin d'éviter que les électrodes 6 n'entrent en contact électrique avec les contre-électrodes 7, une couche isolante est généralement disposée sur les contre-électrodes 7 ou sur les électrodes 6 d'actionnement.

Actuellement, la tension électrique nécessaire pour actionner un commutateur micro-mécanique est typiquement de l'ordre de 40V. Or, la tension électrique disponible dans un appareil portable est généralement de l'ordre de 3V. On cherche alors à concevoir des commutateurs micro-mécaniques fonctionnant à basse tension électrique.

Afin de réduire la tension électrique nécessaire pour la commutation, il serait effectivement possible d'augmenter la longueur du pont et de réduire l'épaisseur du pont. Or, l'épaisseur et la longueur du pont ne peuvent pas être choisies arbitrairement, car elles déterminent les fréquences propres de vibration du pont et, ainsi, la période de commutation caractéristique du pont, c'est-à-dire la vitesse à laquelle fonctionne le commutateur. En effet, un pont ayant une longueur importante et une épaisseur faible présente un temps de commutation longue et une souplesse trop importante qui peut nuire au fonctionnement attendu, par exemple par l'intermédiaire d'une autocommutation liée à des vibrations.

La demande de brevet US2004/0008097 décrit un pont suspendu, au-dessus d'un substrat, à deux extrémités par des plots diélectriques. Le pont comporte quatre moyens d'actionnement disposés au niveau d'une portion centrale du pont. Les moyens d'actionnement sont composés d'une électrode disposée au niveau du substrat et d'une contre électrode disposée au niveau du pont de sorte à faire saillie perpendiculairement à l'axe longitudinal du pont.

### Objet de l'invention

L'invention a pour but de remédier à ces inconvénients et de réaliser un microsystème fonctionnant à basse tension, tout en présentant un temps de commutation court.

Selon l'invention, ce but est atteint par les revendications annexées et, plus particulièrement, par le fait que l'électrode d'actionnement comporte, transversalement au pont, une zone centrale disposée sur le pont et au moins une aile latérale souple en saillie.

### Description sommaire des dessins.

D'autres avantages et caractéristiques ressortiront plus clairement de la description qui va suivre de modes particuliers de réalisation de l'invention donnés à titre d'exemples non limitatifs et représentés aux dessins annexés, dans lesquels :

Les figures 1 et 2 illustrent schématiquement, respectivement en coupe selon l'axe A-A et en vue de dessus, un commutateur selon l'art antérieur.
Les figures 3 et 4 représentent, en vue de dessus, deux modes de réalisation particuliers d'un commutateur selon l'invention.

Les figures 5 à 8 illustrent quatre modes de réalisation particuliers d'une électrode d'actionnement d'un commutateur selon l'invention.

## Description de modes particuliers de réalisation

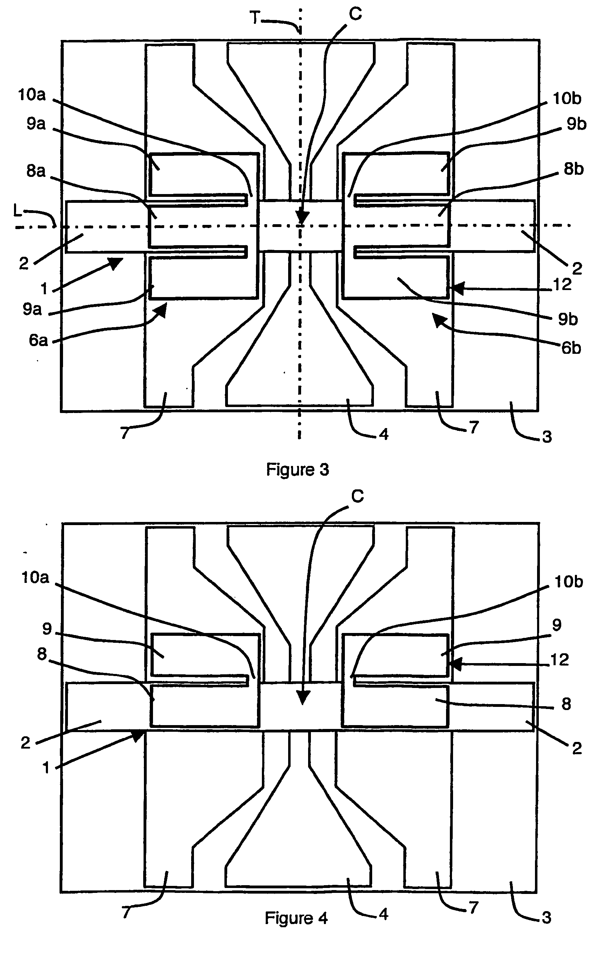

Sur la figure 3 est représenté un axe longitudinal L du pont 1, passant par les deux extrémités 2 du pont 1, et un axe transversal T disposé perpendiculairement à l'axe longitudinal L, dans un plan parallèle au substrat 3. L'intersection des axes transversal T et longitudinal L correspond au centre C du pont 1. Le commutateur représenté à la figure 3 comporte deux électrodes 6 d'actionnement, notamment une première électrode d'actionnement 6a disposée à gauche du centre C du pont, sur la figure 3, et une seconde électrode d'actionnement 6b disposée à droite du centre C du pont, sur la figure 3. Ainsi, les deux électrodes 6 d'actionnement sont disposées, longitudinalement, respectivement de part et d'autre du centre C du pont.

Chaque électrode d'actionnement 6 comporte, transversalement au pont 1, une zone centrale 8, disposée sur le pont 1. Chaque zone centrale 8 peut, par exemple, être disposée à la face supérieure du pont 1 ou à la face inférieure du pont 1. Les zones centrales 8 sont solidaires du pont 1 et disposées, de préférence, entre deux couches isolantes, de manière à être enterrées dans le pont 1.

De plus, sur la figure 3, chaque électrode d'actionnement 6 comporte, transversalement au pont 1, deux ailes 9 latérales en saillie, constituant une paire d'ailes latérales. Sur la figure 3, les deux ailes 9 latérales de chaque électrode 6 d'actionnement sont disposées respectivement de part et d'autre de la zone centrale 8 correspondante et, ainsi, de part et d'autre de l'axe longitudinal L. Les électrodes 6 d'actionnement sont sensiblement planes et disposées dans un plan parallèle au substrat 3. Chaque aile 9 latérale est rattachée à la zone centrale 8 correspondante par une zone de liaison 10 plus étroite, disposée d'un côté de l'aile 9 le plus proche du centre C du pont 1. Ainsi, sur la figure 3, la zone de liaison 10a, rattachant l'aile 9a latérale à la zone centrale 8a de l'électrode 6a de gauche, est disposée sur le côté droit de l'aile 9a et la zone de liaison 10b, rattachant l'aile 9b à la zone centrale 8b de l'électrode 6b de droite, est disposée sur le côté gauche de l'aile 9b.

Ainsi, l'électrode 6b de droite présente la forme de la lettre majuscule E. En effet, sur la figure 3, l'électrode centrale 8b et les ailes 9b forment trois rectangles parallèles, par rapport à leurs axes longitudinaux, et reliés par les zones de liaison 10b qui forment la barre verticale de la lettre majuscule E. L'électrode 6a de gauche présente, de façon analogue, la forme inversée de la lettre majuscule E.

Dans le mode de réalisation particulier représenté à la figure 4, chaque électrode 6 d'actionnement comporte une seule_aile 9 latérale. L'aile 9a latérale de l'électrode 6a et l'aile 9b de l'électrode 6b font saillie du même côté de l'axe longitudinal L.

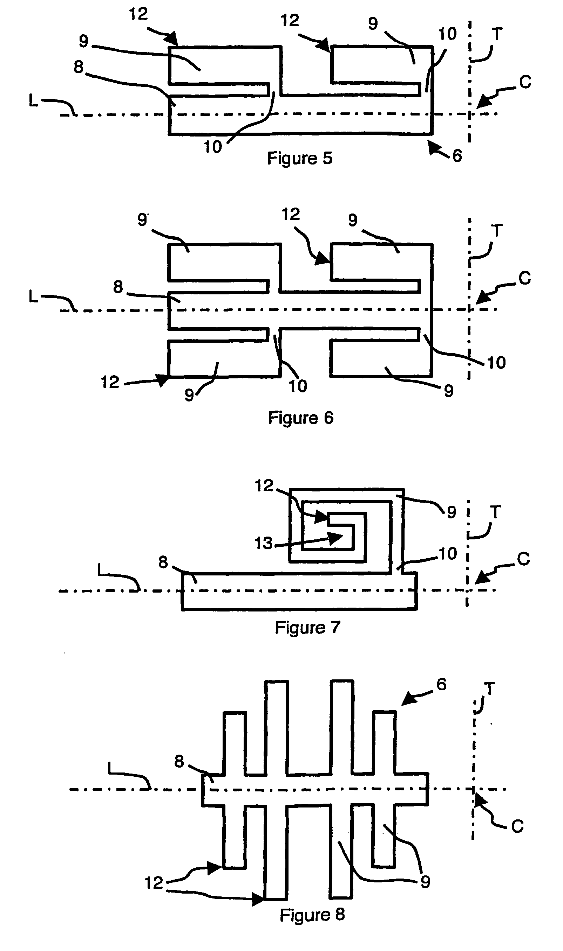

L'électrode 6 d'actionnement représentée à la figure 5 comporte deux ailes 9 latérales faisant saillie du même côté de la zone centrale 8. L'électrode 6 d'actionnement représentée à la figure 6 comporte quatre ailes 9 latérales faisant saillie, deux part deux, respectivement de part et d'autre de la zone centrale 8.

Les électrodes 6 d'actionnement représentées aux figures 5 et 6 sont destinées à être situées à gauche du centre C du pont 1, de manière à ce que les zones de liaison 10 soient disposées du côté de l'aile correspondante le plus proche du centre C du pont, notamment du côté droit de chaque aile 9, comme représenté aux figures 5 et 6.

Ainsi, les ailes 9 latérales des électrodes 6 d'actionnement représentées sur les figures 3 à 6 comportent chacune une extrémité libre 12 disposée du côté de l'aile correspondante le plus éloigné du centre C du pont. Lorsqu'une tension électrique d'actionnement est appliquée entre les électrodes 6 d'actionnement et les contre-électrodes 7, les extrémités libres 12 des ailes 9 latérales fléchissent en direction du substrat 3 et, ainsi, la force attractive électrostatique aux extrémités libres 12 augmente. Ainsi, les extrémités libres 12 fléchissent davantage et entraînent le pont 1 en direction du substrat 3, la force correspondante entre les ailes 9 et le pont 1 étant transmise par l'intermédiaire des zones de liaison 10. Les zones de liaison 10 étant disposées du côté de l'aile 9 le plus proche du centre C du pont, le couple mécanique appliqué au pont 1 par les ailes 9 fléchies est maximal. L'ajout des ailes 9 latérales selon l'invention permet d'obtenir un commutateur ayant une tension électrique d'actionnement de l'ordre de 15V au lieu de 40V pour un commutateur comparable sans ailes.

Une aile 9 comportant une extrémité libre 12 présente automatiquement une raideur plus faible qu'une aile ayant deux extrémités fixées. Par ailleurs, le choix du matériau des ailes 9 et de l'épaisseur des ailes 9 permet d'adapter la raideur des ailes. Les ailes 9 latérales sont, de préférence, enterrées entre deux couches isolantes. L'épaisseur de ces couches isolantes contribue également à la raideur des ailes 9 latérales. De préférence, l'ensemble des ailes 9 latérales, des zones centrales 8 et des couches isolantes associées est constitué par un même empilement de couches comportant au moins une couche conductrice et les couches isolantes.

La forme géométrique des ailes 9 peut être quelconque. En particulier, comme représenté à la figure 7, une aile 9 peut former un serpentin, ayant une extrémité libre 12 disposée près du centre 13 de l'aile 9. Comme précédemment, l'aile 9 est rattachée à la zone centrale 8 correspondante par une zone de liaison 10 plus étroite, disposée du côté de l'aile 9 le plus proche du centre C du pont 1, notamment sur le côté droit de l'aile 9, sur la figure 7. Dans ce cas, l'aile 9 a une longueur développée maximale pour un encombrement très réduit. On peut également envisager d'associer, à une électrode, plusieurs ailes 9 sous forme de serpentin.

Dans tous les cas, les ailes 9 latérales doivent présenter une certaine souplesse, permettant le fléchissement de leurs extrémités libres 12. Dans les modes de réalisation décrits ci-dessus, la souplesse est apportée essentiellement par la zone de liaison 10 plus étroite. Dans une autre variante de l'invention, représentée à la figure 8, l'électrode 6 d'actionnement comporte plusieurs ailes latérales 9 rectangulaires étroites, ayant chacune une longueur très supérieure à sa largeur. La souplesse de chaque aile 9 est alors due au fait que l'aile latérale 9 soit longue et étroite. Sur la figure 8, l'électrode 6 comporte quatre ailes 9 centrales longues et quatre ailes 9 périphériques courtes, formant un peigne de chaque côté de l'électrode 6.

La souplesse des ailes 9 peut être caractérisée quantitativement par l'intermédiaire de la constante de raideur *k* d'une aile ayant une extrémité fixe et une extrémité libre :

$$k = \frac{1}{4} \cdot \frac{E \cdot b \cdot h^3}{l^3} \quad \text{(éq. 1),}$$

où E est le module de Young du matériau de l'aile, b est la largeur de l'aile dans le plan de l'aile parallèle au substrat, h est l'épaisseur de l'aile perpendiculairement au substrat, et I est la longueur effective, c'est-à-dire la longueur développée de l'aile.

La constante de raideur *K* du pont 1 encastré à ses deux extrémités peut être déterminée conformément à l'équation ;

$$K = 16 \cdot \frac{E_p \cdot b_p \cdot h_p^3}{l_p^3} \quad \text{(éq. 2),}$$

où $E_p$ est le module de Young du matériau du pont, $b_p$ est la largeur du pont dans le plan du pont parallèle au substrat, $h_p$ est l'épaisseur du pont perpendiculairement au substrat, et $I_p$ est la longueur du pont.

Tandis que la constante de raideur du pont encastré à ses deux extrémités comporte un facteur 16 dans l'équation 2, l'équation 1 pour une aile ayant une extrémité libre prend un facteur ¼, soit 64 fois moins. Lorsque les autres paramètres sont identiques, une aile ayant une extrémité libre présente donc une raideur beaucoup plus faible qu'une poutre ayant ses deux extrémités encastrées. Ceci est en particulier avantageux lorsque les ailes 9 et le pont 1 sont réalisés par les mêmes étapes et présentent, ainsi, la même épaisseur.

Les ailes 9 ont, de préférence, une épaisseur h de l'ordre du micromètre et une largeur b comprise entre 30 et 50 micromètres. La longueur I effective, c'est-

à-dire la longueur développée de l'aile 9, est, par exemple, comprise entre 100 et 200 micromètres pour un commutateur ayant une tension électrique d'actionnement de 15V, Plus la longueur effective de l'aile est importante, plus la tension électrique d'actionnement du commutateur peut être réduite. Lorsque la longueur effective est de l'ordre de 500 micromètres, une tension électrique d'actionnement de 3V peut être envisagée.

Les ailes 9 et, éventuellement, le pont 1 sont, de préférence, réalisés en oxyde de silicium $SiO_2$ ou en nitrure de silicium SIN. D'autres matériaux peuvent être choisis, par exemple des métaux. Dans ce dernier cas, des isolants électriques doivent être prévus pour isoler les ailes métalliques des éléments ayant des fonctions électriques comme les différentes électrodes. L'invention n'est pas limitée aux modes de réalisation représentés. En particulier, le nombre d'électrodes 6 d'actionnement peut être quelconque. Par exemple, une électrode 6 d'actionnement unique peut être suffisante, mais on peut également envisager la réalisation de plusieurs électrodes 6 d'actionnement de chaque côté du centre C du pont. De plus, on peut envisager toute combinaison des différentes électrodes 6 d'actionnement représentées. Par ailleurs, l'invention s'applique à tout type de microsystèmes comportant un pont déformable, par exemple les commutateurs, les miroirs mobiles, etc...

**Revendications**

1. Microsystème comportant un pont (1) déformable, ayant deux extrémités (2) et un axe longitudinal passant par ses deux extrémités (2), le pont (1) étant rattaché uniquement par ses deux extrémités (2) à un substrat (3), le microsystème comportant des moyens d'actionnement destinés à déformer le pont (1) déformable perpendiculairement au substrat (3), de manière à ce qu'une zone centrale de la face inférieure du pont vienne en contact avec au moins un élément de contact (4) formé sur ledit substrat (3), les moyens d'actionnement comportant au moins une électrode (6) d'actionnement solidaire du pont (1) et disposée, entre le centre (C) du pont et une des extrémités (2), vis-à-vis d'une contre-électrode (7) solidaire du substrat (3), perpendiculairement à l'axe longitudinal du pont (1) l'électrode (6) d'actionnement comportant une zone centrale (8) disposée sur le pont (1) et au moins une aile (9) latérale souple en saillie, microsystème **caractérisé en ce que** ladite aile (9) latérale souple en saillie est plus souple que le pont (1) déformable.

2. Microsystème selon la revendication 1, **caractérisé en ce que** l'aile (9) latérale est rattachée à la zone centrale (8) par une zone de liaison (10) plus étroite, disposée d'un côté de l'aile (9) le plus proche du centre (C) du pont.

**3.** Microsystème selon la revendication 2, **caractérisé en ce que** l'aile (9) latérale forme un serpentin.

**4.** Microsystème selon la revendication 1, **caractérisé en ce que** l'aile (9) latérale a une forme rectangulaire étroite.

**5.** Microsystème selon l'une quelconque des revendication 1 à 4, **caractérisé en ce qu'**il comporte au moins deux électrodes (6) d'actionnement disposées respectivement de part et d'autre du centre (C) du pont.

**6.** Microsystème selon l'une quelconque des revendications 1 à 5, **caractérisé en ce que** chaque électrode (6) d'actionnement comporte au moins une paire d'ailes (9) latérales disposées respectivement de part et d'autre de la zone centrale (8) correspondante.

**7.** Microsystème selon l'une quelconque des revendications 1 à 6, **caractérisé en ce que** chaque électrode (6) d'actionnement comporte au moins deux ailes (9) latérales faisant saillie du même côté de la zone centrale (8).

**8.** Microsystème selon l'une quelconque des revendications 1 à 7, **caractérisé en ce que** la raideur d'une aile latérale (9) ayant une extrémité libre et une extrémité fixe est définie par une constante de raideur k représentative de l'équation $k = \frac{1}{4} \cdot \frac{E \cdot b \cdot h^3}{l^3}$ dans laquelle E représente le module de Young du matériau de l'aile (9), b est la largeur de l'aile (9) dans le plan de l'aile (9) parallèle au substrat (3), h est l'épaisseur de l'aile (9) perpendiculairement au substrat (3), et l la longueur développée de l'aile (9).

**9.** Microsystème selon l'une quelconque des revendications 1 à 8, **caractérisé en ce que** la raideur du pont (1) déformable encastré à ses deux extrémités est définie par une constante de raideur K, représentative de l'équation $K = 16 \cdot \frac{E_p' \cdot b_p \cdot h_p^{\,3}}{l_p^{\,3}}$ dans laquelle $E_p$ représente le module de Young du matériau du pont (1), $b_p$ est la largeur du pont (1) dans le plan du pont (1) parallèle au substrat (3), $h_p$ est l'épaisseur du pont (1) perpendiculairement au substrat (3), et $l_p$ la longueur du pont (1).

**Claims**

**1.** Microsystem comprising a deformable bridge (1) having two ends (2) and a longitudinal axis passing through its two ends (2), the bridge (1) being attached only via its ends (2) to a substrate (3), the microsystem comprising actuating means designed to deform the deformable bridge (1) perpendicularly to the substrate (3) so that a central zone of the bottom face of the bridge comes into contact with at least one contact element (4) formed on said substrate (3), the actuating means comprising at least one actuating electrode (6) fixedly secured to the bridge (1) and disposed between the centre (C) of the bridge and one of the ends (2) thereof, facing a counterelectrode (7) fixedly secured to the substrate (3), perpendicularly to the longitudinal axis of the bridge (1) the actuating electrode (6) comprising a central zone (8) disposed on the bridge (1) and at least one projecting flexible lateral flange (9), microsystem charaterized in that said projecting flexible lateral flange (9) is more flexible than the deformable bridge (1).

**2.** Microsystem according to claim 1, **characterized in that** the lateral flange (9) is attached to the central zone (8) by a narrower connecting zone (10) disposed on the side of the flange (9) that is closer to the centre (C) of the bridge.

**3.** Microsystem according to claim 2, **characterized in that** the lateral flange (9) forms a coil.

**4.** Microsystem according to claim 1, **characterized in that** the lateral flange (9) has a narrow rectangular shape.

**5.** Microsystem according to any one of the claims 1 to 4, **characterized in that** it comprises at least two actuating electrodes (6) respectively disposed on each side of the centre (C) of the bridge.

**6.** Microsystem according to any one of the claims 1 to 5, **characterized in that** each actuating electrode (6) comprises at least one pair of lateral flanges (9) respectively disposed on each side of the corresponding central zone (8).

**7.** Microsystem according to any one of the claims 1 to 6, **characterized in that** each actuating electrode (6) comprises at least two lateral flanges (9) projecting on the same side of the central zone (8).

**8.** Microsystem according to any one of the claims 1 to 7, **characterized in that** the stiffness of a lateral flange (9) having a free end and a fixed end is defined by a stiffness constant k representative of the equation $k = \frac{1}{4} \cdot \frac{E \cdot b \cdot h^3}{l^3}$ where E is the Young's modulus of the material of the flange (9), b is the width of the flange (9) in the plane of the flange (9) parallel to the substrate (3), h is the thickness of the flange (9) perpendicularly to the substrate (3), and I is the effective length of the flange (9).

9. Microsystem according to any one of the claims 1 to 8, **characterized in that** the stiffness of the deformable bridge (1) embedded at its both ends is defined by a stiffness constant K representative to the equation

$$K = 16 \cdot \frac{E_p \cdot b_p \cdot h_p{}^3}{l_p{}^3}$$ where $E_p$ is the Young's modulus of the material of the bridge (1), $b_p$ is the width of the bridge (1) in the plane of the bridge (1) parallel to the substrate (3), $h_p$ is the thickness of the bridge (1) perpendicularly to the substrate (3), and $l_p$ is the length of the bridge (1).

**Patentansprüche**

1. Mikrosystem mit einer verformbaren Brücke (1), die zwei Enden (2) und eine Längsachse hat, die durch ihre zwei Enden (2) verläuft, wobei die Brücke (1) nur durch ihre zwei Enden (2) an einem Substrat (3) befestigt ist, wobei das Mikrosystem Betätigungsmittel aufweist, die dazu bestimmt sind, die verformbare Brücke (1) senkrecht zu dem Substrat (3) zu verformen, sodass eine zentrale Zone der Unterseite der Brücke mit wenigstens einem auf dem Substrat (3) gebildeten Kontaktelement (4) in Kontakt gelangt, wobei die Betätigungsmittel wenigstens eine mit der Brücke (1) fest verbundene Elektrode (6) aufweisen, die zwischen dem Zentrum (C) der Brücke und einem der Enden (2) gegenüber einer mit dem Substrat (3) fest verbundenen Gegenelektrode (7) senkrecht zu der Längsachse der Brücke (1) angeordnet ist, wobei die Betätigungselektrode (6) eine an der Brücke (1) angeordnete zentrale Zone (8) und wenigstens einen seitlichen elastisch vorspringenden Flügel (9) aufweist, wobei das Mikrosystem **dadurch gekennzeichnet ist, dass** der seitliche elastisch vorspringende Flügel (9) elastischer als die verformbare Brücke (1) ist.

2. Mikrosystem nach Anspruch 1, **dadurch gekennzeichnet, dass** der seitliche Flügel (9) an der zentralen Zone (8) durch eine schmalere Verbindungszone (10) befestigt ist, die an einer Seite des Flügels (9) dem Zentrum (C) der Brücke am nächsten angeordnet ist.

3. Mikrosystem nach Anspruch 2, **dadurch gekennzeichnet, dass** der seitliche Flügel (9) eine Schlange bildet.

4. Mikrosystem nach Anspruch 1, **dadurch gekennzeichnet, dass** der seitliche Flügel (9) eine schmale rechteckige Form hat.

5. Mikrosystem nach einem der Ansprüche 1 bis 4, **dadurch gekennzeichnet, dass** es wenigstens zwei Betätigungselektroden (6) aufweist, die jeweils beiderseits des Zentrums (C) der Brücke angeordnet sind.

6. Mikrosystem nach einem der Ansprüche 1 bis 5, **dadurch gekennzeichnet, dass** jede Betätigungselektrode (6) wenigstens ein Paar seitliche Flügel (9) aufweist, die jeweils beiderseits der entsprechenden zentralen Zone (8) angeordnet sind.

7. Mikrosystem nach einem der Ansprüche 1 bis 6, **dadurch gekennzeichnet, dass** jede Betätigungselektrode (6) wenigstens zwei seitliche Flügel (9) aufweist, die an der gleichen Seite der zentralen Zone (8) vorspringen.

8. Mikrosystem nach einem der Ansprüche 1 bis 7, **dadurch gekennzeichnet, dass** die Steifigkeit eines seitlichen Flügels (9) mit einem freien Ende und einem festgelegten Ende durch eine Steifigkeitskonstante k definiert ist, für welche folgende Gleichung repräsentativ ist:

$$k = \frac{1}{4} \cdot \frac{E \cdot b \cdot h^3}{l^3}$$, worin E das Young-Modul des Materials des Flügels (9) darstellt, b die Breite des Flügels (9) in der Ebene des Flügels (9) parallel zu dem Substrat (3) ist, h die Dicke des Flügels (9) senkrecht zu dem Substrat ist, und 1 die Länge des Flügels (9) ist.

9. Mikrosystem nach einem der Ansprüche 1 bis 8, **dadurch gekennzeichnet, dass** die Steifigkeit der verformbaren, an ihren beiden Enden eingespannten Brükke durch eine Steifigkeitskonstante k definiert ist, für welche folgende Gleichung repräsentativ ist:

$$K = 16 \cdot \frac{E_p \cdot b_p \cdot h_p{}^3}{l_p{}^3}$$, worin $E_p$ das Young-Modul

des Materials der Brücke (1) darstellt, $b_p$ die Breite der Brücke (1) in der Ebene der Brücke (1) parallel zu dem Substrat (3) ist, $h_p$ die Dicke der Brücke (1) senkrecht zu dem Substrat ist, und $l_p$ die Länge der Brücke (1) ist.

Figure 1 (Art antérieur)

Figure 2 (Art antérieur)

Figure 3

Figure 4

Figure 5

Figure 6

Figure 7

Figure 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040008097 A